# EUROPEAN PATENT APPLICATION

(11) **EP 4 768 968 A1**
(43) Date of publication of application: **01.07.2026**
(21) Application number: 24894322.7
(22) Date of filing: 30.08.2024
(51) Int. Cl.: G01R 31/396, G01R 31/3828, G01R 31/392, G01R 31/389, G01R 31/374, G01R 31/367

(54) **BATTERY MANAGEMENT DEVICE, BATTERY MANAGEMENT METHOD, AND BATTERY MANAGEMENT SYSTEM**

(30) Priority: 20.11.2023 KR 20230160215
(71) Applicant: LG Energy Solution, Ltd., Seoul 07335 (KR)
(72) Inventor: CHUNG, Mi Kyung, Daejeon 34122 (KR); KOH, Dong Wook, Daejeon 34122 (KR); CHUN, Joo Young, Daejeon 34122 (KR)
(74) Representative: Goddar, Heinz J.
(86) International application number: PCT/KR2024/013036
(87) International publication number: WO 2025/110426

(57) **Abstract**

A battery management apparatus according to some embodiments disclosed herein includes a sensor configured to collect battery data from a management target battery and a controller configured to extract, from the battery data, a dataset regarding charging/discharging rate and a voltage for each of a plurality of reference state of charge (SOC) values, generate a first profile of a voltage with respect to a charging/discharging rate by performing fitting on the dataset at each reference SOC value, generate a second profile of a voltage with respect to an SOC for each of a plurality of charging/discharging rates based on the first profile at each reference SOC value, and estimate a state of the management target battery based on a plurality of second profiles corresponding to the plurality of charging/discharging rates.

## Description

### TECHNICAL FIELD

### CROSS-REFERENCE TO RELATED APPLICATION

This application claims priority to and the benefit of Korean Patent Application No. 10-2023-0160215 filed in the Korean Intellectual Property Office on November 20, 2023, the entire content of which is incorporated herein by reference.

### TECHNICAL FIELD

Embodiments disclosed herein relate to a battery management apparatus, a battery management method, and a battery management system.

### BACKGROUND ART

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Among secondary batteries, lithium-ion batteries may have a higher energy density than conventional Ni/Cd batteries, Ni/MH batteries, etc., and may be manufactured to be small and lightweight, allowing them to have high usability in terms of power sources for mobile devices. Recently, the lithium-ion battery is attracting attention as a next-generation energy storage medium as a usage range thereof is expanded to a power source of electric vehicles.

Battery data such as a voltage, a current, a temperature, a state of charge (SOC), etc., may be analyzed to estimate a state of a battery used in a vehicle, etc. For example, a state of a battery such as resistance degradation may be diagnosed, and to this end, a process of separating battery data mixed for a plurality of charging/discharging rates (Crates) for each charging/discharging speed may be performed. Meanwhile, performance of state diagnosis may vary depending on a method of fitting data in the separating process for the charging/discharging speed.

### DISCLOSURE

### TECHNICAL PROBLEM

Embodiments disclosed herein aim to provide a battery management apparatus, a battery management method, and a battery management system in which a data fitting method may be advanced in a process of separating battery data for each charging/discharging speed to improve performance of state diagnosis.

Technical problems of the embodiments disclosed herein are not limited to the above-described technical problems, and other unmentioned technical problems would be clearly understood by one of ordinary skill in the art from the following description.

### TECHNICAL SOLUTION

According to some embodiments disclosed herein, a battery management apparatus includes a sensor configured to collect battery data from a management target battery and a controller configured to extract, from the battery data, a dataset regarding charging/discharging rate and a voltage for each of a plurality of reference state of charge (SOC) values, generate a first profile of a voltage with respect to a charging/discharging rate by performing fitting on the dataset at each reference SOC value, generate a second profile of a voltage with respect to an SOC for each of a plurality of charging/discharging rates based on the first profile at each reference SOC value, and estimate a state of the management target battery based on a plurality of second profiles corresponding to the plurality of charging/discharging rates.

According to some embodiments, the controller may be further configured to generate the first profile by performing optimized polynomial fitting on the dataset at each reference SOC value.

According to some embodiments, the controller may be further configured to determine a polynomial order that is most appropriate for the dataset and generate the first profile by minimizing a difference between the dataset of the estimated polynomial expression according to the polynomial order.

According to some embodiments, the controller may be further configured to generate a third profile of a resistance of the management target battery with respect to an SOC based on the plurality of second profiles and estimate a resistance degradation state of the management target battery based on the third profile.

According to some embodiments, the controller may be further configured to estimate the resistance degradation state by comparing the third profile with a resistance profile at a manufacturing time of the management target battery.

According to an embodiment, the controller may be further configured to generate correction data by performing current accumulation and Kalman filter error correction on the battery data and extract the dataset based on the correction data.

According to some embodiments, the sensor may be configured to collect the battery data from the management target battery charged or discharged by a power-using device including the management target battery.

According to some embodiments disclosed herein, a battery management method includes collecting battery data from a management target battery, extracting, from the battery data, a dataset regarding a charging/discharging rate and a voltage for each of a plurality of reference state of charge (SOC) values, generating a first profile of a voltage with respect to a charging/discharging rate by performing fitting on the dataset at each reference SOC value, generating a second profile of a voltage with respect to an SOC for each of a plurality of charging/discharging rates based on the first profile at each reference SOC value, and estimating a state of the management target battery based on a plurality of second profiles corresponding to the plurality of charging/discharging rates.

According to some embodiments, the generating of the first profile may include generating the first profile by performing optimized polynomial fitting on the dataset at each reference SOC value.

According to some embodiments, the generating of the first profile may include determining a polynomial order that is most appropriate for the dataset and generating the first profile by minimizing a difference between the dataset of the estimated polynomial expression according to the polynomial order.

According to some embodiments, the battery management method may further include generating a third profile of a resistance of the management target battery with respect to an SOC based on the plurality of second profiles and estimating a resistance degradation state of the management target battery based on the third profile.

According to some embodiments, the estimating of the resistance degradation state may include estimating the resistance degradation state by comparing the third profile with a resistance profile at a manufacturing time of the management target battery.

According to some embodiments, the extracting of the dataset may include generating correction data by performing current accumulation and Kalman filter error correction on the battery data and extracting the dataset based on the correction data.

According to some embodiments, the collecting of the battery data may include collecting the battery data from the management target battery charged or discharged by a power-using device including the management target battery.

According to some embodiments disclosed herein, a battery management system includes a management target battery charged or discharged by a power-using device and a battery management apparatus configured to collect battery data from a management target battery, extract, from the battery data, a dataset regarding charging/discharging rate and a voltage for each of a plurality of reference state of charge (SOC) values, generate a first profile of a voltage with respect to a charging/discharging rate by performing fitting on the dataset at each reference SOC value, generate a second profile of a voltage with respect to an SOC for each of a plurality of charging/discharging rates based on the first profile at each reference SOC value, and estimate a state of the management target battery based on a plurality of second profiles corresponding to the plurality of charging/discharging rates.

### ADVANTAGEOUS EFFECTS

According to embodiments disclosed herein, there may be provided a battery management apparatus, a battery management method, and a battery management system in which a data fitting method may be advanced in a process of separating battery data for each charging/discharging speed to improve performance of state diagnosis.

The technical effects according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 illustrates components of a battery management system according to some embodiments.
FIG. 2 illustrates components of a battery management apparatus according to some embodiments.
FIG. 3 illustrates a process of generating cumulative data of a voltage with respect to an SOC by measuring battery data, according to some embodiments.
FIG. 4 illustrates an SOC and a voltage of battery data according to some embodiments.
FIGS. 5 to 7 illustrate a dataset in each reference SOC value and a first profile through data fitting therefor, according to some embodiments.
FIG. 8 illustrates a second profile for each of a plurality of charging/discharging rates, according to some embodiments.
FIG. 9 illustrates a third profile of a battery resistance with respect to an SOC, according to some embodiments.
FIG. 10 illustrates operations of a battery management method according to some embodiments.

### MODE FOR INVENTION

Hereinafter, embodiments disclosed herein will be described with reference to the accompanying drawings. However, the description is not intended to limit the disclosure of the present document to particular embodiments, and it should be construed as including various modifications, equivalents, and/or alternatives according to the embodiments described herein.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two driver devices directly. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

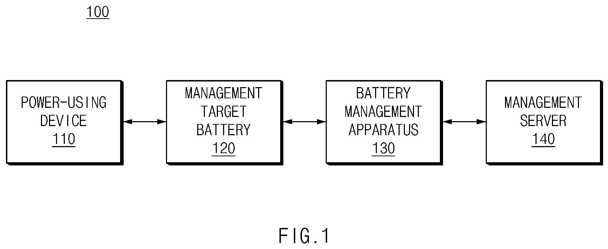

FIG. 1 illustrates components of a battery management system according to some embodiments.

Referring to FIG. 1, a battery management system 100 may include a power-using device 110, a management target battery 120, a battery management apparatus 130, and a management server 140. However, without being limited thereto, some components may be omitted from the battery management system 100 or other general-purpose components may be further included in the battery management system 100.

The battery management system 100 may refer to a system for diagnosing the management target battery 120 and managing a state thereof. When the management target battery 120 is charged or discharged by the power-using device 110, corresponding battery data of the management target battery 120 may be measured and analyzed by the battery management apparatus 130.

The power-using device 110 may be configured to charge or discharge the management target battery 120. The power-using device 110 may discharge the management target battery 120 while consuming power, and charge the management target battery 120 while generating power. According to an embodiment, the power-using device 110 may include a mobility device such as an electric vehicle, an electric bicycle, etc. The mobility device may drive a motor based on power of the management target battery 120 or charge the management target battery 120 with power generated through regenerative breaking.

The management target battery 120 may include a battery pack, etc., that is a target for management of the battery management system 100. A battery pack of the management target battery 120 may include a plurality of battery modules, and each battery module may include a plurality of battery cells. According to an embodiment, the management target battery 120 may be mounted on a mobility device such as an electric vehicle, an electric bicycle, etc.

The battery management apparatus 130 may perform operations for diagnosing or managing the management target battery 120. The battery management apparatus 130 may measure battery data from the management target battery 120 and diagnose or manage a state of the management target battery 120 based on the battery data.

The management server 140 may manage a result of diagnosis of the battery management apparatus 130. The management server 140 may exchange data with the battery management apparatus 130 in a wired/wireless communication manner. When a failure of the management target battery 120 is diagnosed or a lifespan thereof is predicted, corresponding results may be transmitted to the management server 140 and recorded in a database.

According to an embodiment, the management server 140 may perform operations for managing the management target battery 120, in place of the battery management apparatus 130. According to an embodiment, the battery management apparatus 130 may perform diagnosis operations by executing battery management software, and the management server 140 may provide update information of the battery management software to the battery management apparatus 130.

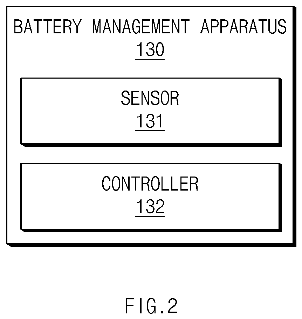

FIG. 2 illustrates components of a battery management apparatus according to some embodiments.

Referring to FIG. 2, the battery management apparatus 130 may include a sensor 131 and a controller 132. However, without being limited thereto, some components may be omitted from the battery management apparatus 130 or other general-purpose components may be further included in the battery management apparatus 130.

According to an embodiment, the sensor 131 and the controller 132 of the battery management apparatus 130 may be electrically connected to one another in a device-to-device communication manner. The device-to-device communication manner may include a general-purpose input and output (GPIO), a serial peripheral interface (SPI), a mobile industry processor interface (MIPI), etc.

The sensor 131 may be configured to generate various battery measurement values from the management target battery 120. To this end, the sensor 131 may include measuring means such as a voltage sensor, a current sensor, a temperature sensor, etc.

The controller 132 may have a structure for executing instructions that implement the operations of the battery management apparatus 130. The controller 132 may be implemented with an array of multiple logic gates or a general-purpose microprocessor for processing various operations, and may include a single processor or a plurality of processors. For example, the controller 132 may be implemented in the form of at least one of a microprocessor, a CPU, a GPU, and an AP.

The controller 132 may operate with a memory configured to store various data, instructions, mobile applications, computer programs, etc. The memory may be configured separately from or integrally with the controller 132. The controller 132 may execute instructions stored in the memory to process various calculation. For example, the memory may be implemented in the form of a non-volatile memory device such as ROM, PROM, EPROM, EEPROM, flash memory, PRAM, MRAM, RRAM, FRAM, etc., or a volatile memory device such as DRAM, SRAM, SDRAM, RRAM, etc., or HDD, SSD, SD, Micro- SD, etc., or may be implemented in the form of a combination thereof.

The sensor 131 may be configured to collect battery data from the management target battery 120. The battery data may include a voltage, a current, a temperature, etc., of the management target battery 120, measured at specific intervals. According to an embodiment, an SOC of the management target battery 120 may be derived based on the voltage, the current, the temperature, etc., of the battery data, and a charging/discharging state (C-rate (CR)) of the management target battery 120 may be derived based on the current, etc., of the battery data. When the charging/discharging state is 0, the management target battery 120 may be in an open circuit state and in this case, the voltage may be an open circuit voltage (OCV). A sign (+/-) of the charging/discharging state may indicate whether the management target battery 120 is in a charging state or a discharging state.

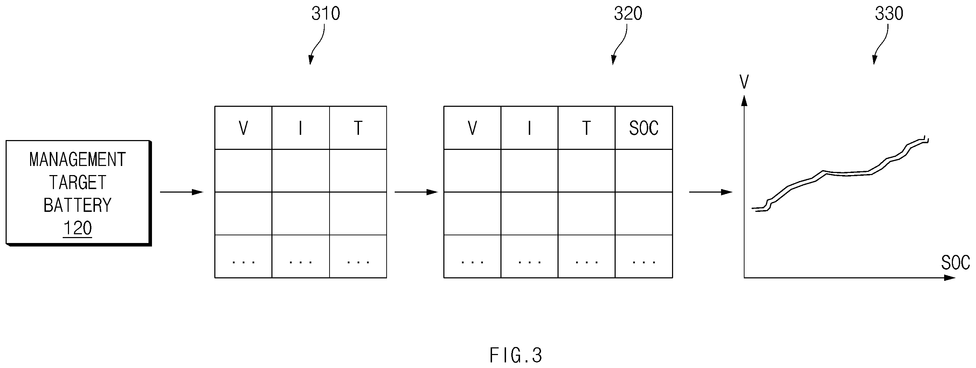

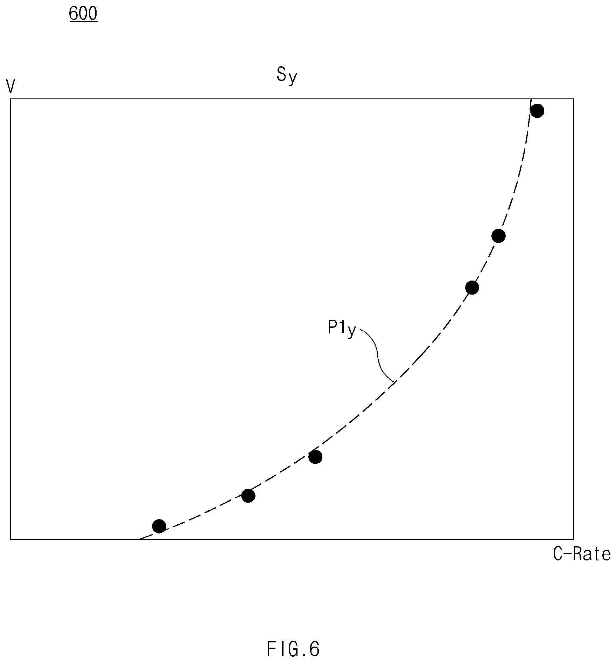

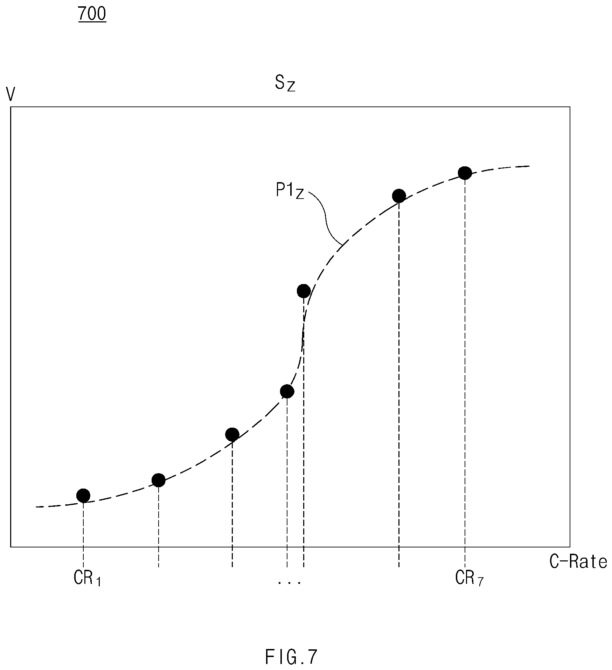

The controller 132 may be configured to extract, from the battery data, a dataset Si regarding a charging/discharging speed (C-rate (CR)) and a voltage for each of a plurality of reference SOC values SOC1 to SOCn. Hereinbelow, FIGS. 3 to 7 will be referred to. The battery data may include a plurality of measurement values generated every measurement period, and a measurement value at each point in time may include a voltage value, a current value, and a temperature value, and an SOC value at each point in time may be further derived. According to an embodiment, a graph 330 plotting data indicating an SOC value and a voltage value at each point in time may be generated, and the dataset Si may be extracted based on the graph 330. For example, SOC-voltage data corresponding to reference SOC values (SOCx, SOCy, SOCz) may be extracted to generate datasets (Sx, Sy, Sz).

The controller 132 may be configured to generate a first profile P1i of a voltage with respect to a charging/discharging speed CR by performing fitting on the dataset Si at each reference SOC value SOCi. For example, a dataset Sx may be generated by extracting measurement values having a specific SOC value SOCx in cumulative data of an SOC-voltage measured at a plurality of points in time as in the graph 330. The dataset Sx may have a charging/discharging speed CR and a voltage V as in a graph 500, and a first profile P1x that best fits a pattern of the dataset Sx may be derived. For example, the first profile P1x may be expressed as a first-order polynomial expression.

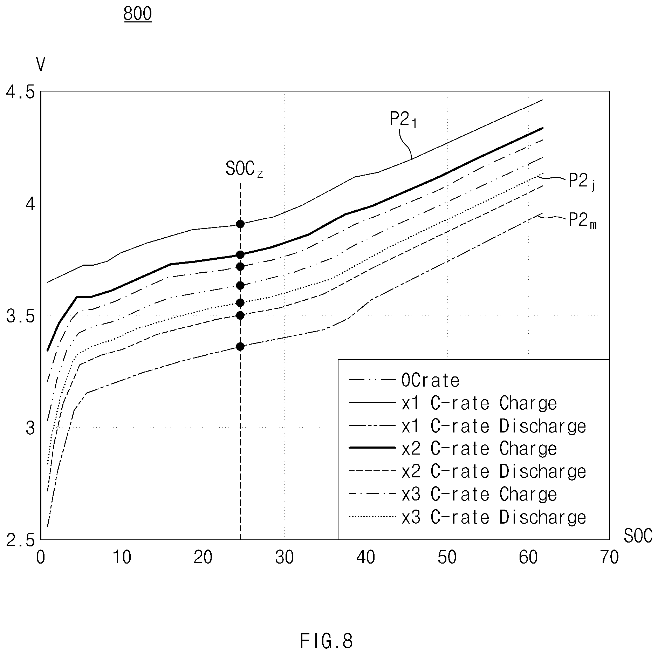

The controller 132 may be configured to generate a second profile P2j of a voltage with respect to an SOC for each of a plurality of charging/discharging rates CR1 to CRm based on the first profile P1i at each reference SOC value SOCi. The second profile P2j may be described with reference to FIG. 8 provided below. For example, a method of transferring seven points for a reference SOC value Sz of a graph 700 to a graph 800 may be repeated for a plurality of reference SOC values S1 to S1n to generate second profiles P2₁ to P2ₘ for a plurality of charging/discharging rates CR1 to CRm.

The controller 132 may be configured to estimate a state of the management target battery 120 based on the plurality of second profiles P2₁ to P2ₘ corresponding to the plurality of charging/discharging rates CR1 to CRm. Resistance degradation SOHR of the management target battery 120 may be diagnosed based on the plurality of second profiles P2₁ to P2ₘ, and the lifetime of the management target battery 120 may be estimated based on a value of the resistance degradation SOHR. For example, for the specific SOC value SOCz of the graph 800, the plurality of charging/discharging rates CR1 to CRm and the plurality of voltage values may be provided, and thus based on them, a resistance value of the management target battery 120 for the specific SOC value SOCz may be estimated.

According to an embodiment, the controller 132 may be configured to generate the first profile P1i by performing optimized polynomial fitting on the dataset Si at each reference SOC value SOCi. For example, the dataset Sx of the graph 500 may be fitted with a first-order polynomial expression P1x, while the dataset Sy of the graph 600 may be fitted with a second-order polynomial expression P1y. As fitting may be performed with a polynomial expression that best fits the pattern of the dataset Si, the accuracy of data fitting and the performance of state diagnosis may be improved compared to when fitting is uniformly performed with a linear or quadratic equation.

According to an embodiment, the controller 132 may be configured to determine a polynomial order that is most appropriate for the dataset Si and minimize a difference between the dataset Si of an estimated polynomial expression according to the polynomial order, thereby generating the first profile P1i. To this end, various curve fitting models may be used, and after the polynomial order is determined, coefficients of an estimated polynomial expression may be adjusted using least squares, etc.

According to an embodiment, the controller 132 may be further configured to generate a third profile P3 of a resistance of the management target battery 120 with respect to an SOC based on the plurality of second profiles P2₁ to P2ₘ and estimate a resistance degradation state of the management target battery 120 based on the third profile P3. For example, resistance degradation SOHRi may be estimated using the plurality of charging/discharging rates CR1 to CRm and the plurality of voltage values at each reference SOC value SOCi, and this process may be repeated for the reference SOC values SOC1 to SOCn, thereby generating the third profile P3 of SOHR with respect to an SOC.

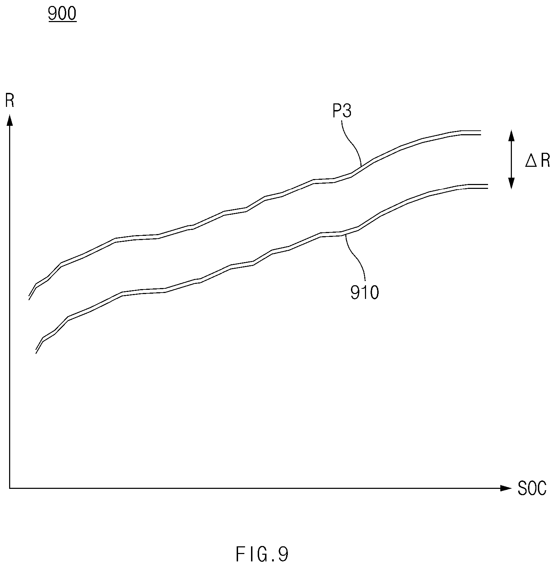

According to an embodiment, the controller 132 may be configured to estimate a resistance degradation state by comparing the third profile P3 with a resistance profile at the time of manufacturing the management target battery 120. For example, as in a graph 900 of FIG. 9 described below, as degradation of the management target battery 120 progresses, a resistance of the management target battery 120 may increase and thus may be compared with a reference point in time, such that the resistance degradation state may be estimated.

According to an embodiment, the controller 132 may be configured to generate correction data by performing current accumulation and Kalman filter error correction on the battery data and extract the dataset Si based on the correction data. The current accumulation may include a method of processing the battery data by accumulating a current value, thereby generating SOC-voltage data. Thus, by performing error correction through a Kalman filter, a data plot such as the graph 330 may be formed.

According to an embodiment, the sensor 131 may be configured to collect the battery data from the management target battery 120 charged or discharged by the power-using device including the management target battery 120. For example, the power-using device may include an electric vehicle, and during charging or discharging of the management target battery 120 by a motor of an electric vehicle, a voltage, a current, a temperature, etc., may be measured at each point in time at specific intervals.

FIG. 3 illustrates a process of generating cumulative data of a voltage with respect to an SOC by measuring battery data, according to some embodiments.

Referring to FIG. 3, a process of generating the graph 330 of the cumulative data of a voltage with respect to an SOC by measuring battery data 310 from the management target battery 120 may be shown. The graph 330 of the cumulative data may include a plurality of SOC-voltage matching values.

According to an embodiment, SOC data 320 may be derived from the battery data 310 through current accumulation or other appropriate methods. Herein, depending on a need, error correction using a Kalman filter, etc., may be performed. The battery data 310 and the SOC data 320 may include a plurality of data measured at a plurality of points in time. An SOC value and a voltage value in the SOC data 320 may be set as one point and a plurality of points may be plotted in two dimensions, thereby generating the graph 330 of the cumulative data.

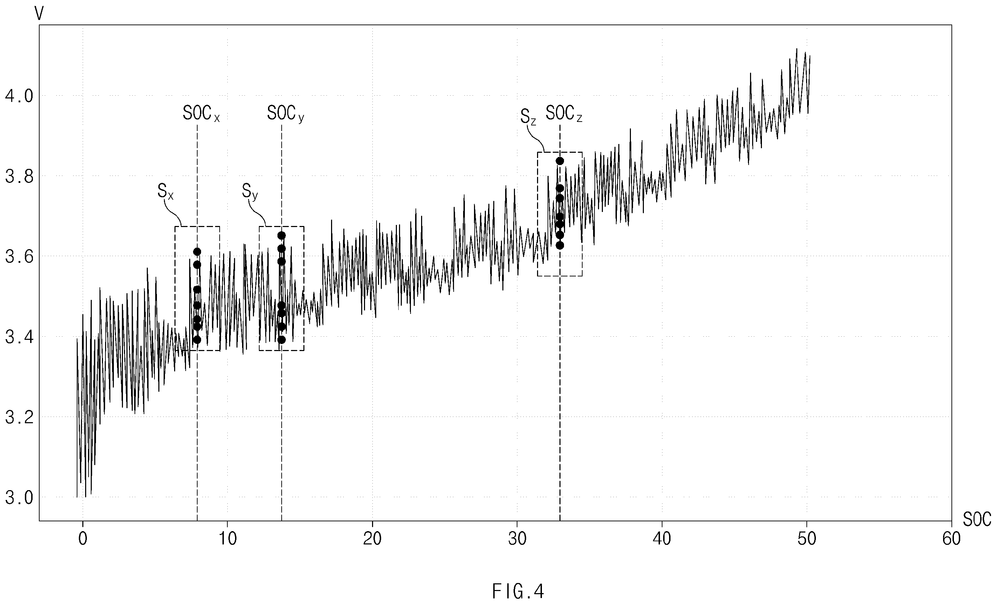

FIG. 4 illustrates an SOC and a voltage of battery data according to some embodiments.

Referring to FIG. 4, the graph 330 may be shown in which data points of an SOC and a voltage derived from the battery data may be cumulatively indicated. The graph 330 may show SOC-voltage matching values measured for the plurality of charging/discharging rates CR1 to CRm without distinguishment.

The graph 330 may need a process for distinguishment because the SOC-voltage matching values may be indicated without distinguishment for the plurality of charging/discharging rates CR1 to CRm. For example, data points for the reference SOC values (Sx, Sy, Sz, etc.) may be extracted, and the extracted points may be processed from different perspectives, thereby enabling the data points from being distinguished from each other for the plurality of charging/discharging rates CR1 to CRm. Upon completion of distinguishment, the plurality of data points of the graph 330 may be separated into the plurality of second profiles P2₁ to P2ₘ of the graph 900.

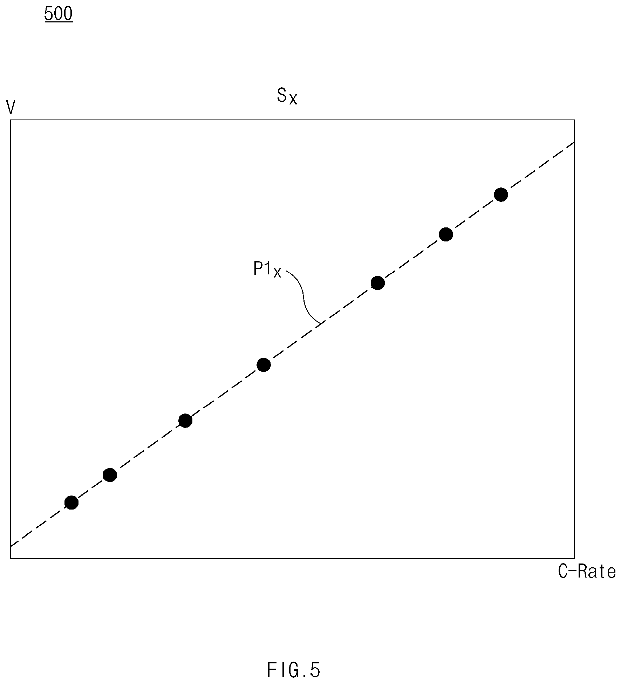

FIGS. 5 to 7 illustrate a dataset in each reference SOC value and a first profile through data fitting therefor, according to some embodiments.

Referring to FIGS. 5 to 7, graphs 500, 600, and 700 for describing optimized polynomial fitting for some datasets (Sx, Sy, Sz) may be shown. Each dataset Si may include matching values of a charging/discharging speed CR and a voltage, and the number of data may vary with a driving pattern, a battery usage time, etc., of the vehicle.

According to a data distribution pattern of each dataset Si, each dataset Si may be fitted with a polynomial expression of the most appropriate order. For example, the dataset Sx of the graph 500 may be fitted with a first-order polynomial expression, while the dataset Sy of the graph 600 may be fitted with a second-order polynomial expression. In this way, as fitting orders of various patterns may not be fixed, the performance of data fitting and the accuracy of state diagnosis may be improved. Upon completion of data fitting through optimized polynomial fitting in each dataset Si, even for charging/discharging speed CR values for which there is no measurement point, a voltage value at that value may be estimated.

FIG. 8 illustrates a second profile for each of a plurality of charging/discharging rates, according to some embodiments.

Referring to FIG. 8, a graph 800 showing a second profile P2j for each of the plurality of charging/discharging rates CR1 to CRm may be shown. The graph 800 may separately indicate the data points of the graph 330 with respect to the plurality of charging/discharging rates CR1 to CRm.

The second profile P2j may be generated by collecting a voltage value at each SOC value for a specific charging/discharging rate CRj. For example, the voltage values at some SOC values SOCz in the graph 700 may be indicated in the graph 800, and this method may be repeated for other SOC values to form the second profile P2j.

The graph 800 may include second profiles P21 to P27 for 0 CR, ±1 CR, ±2 CR, and ±3 CR. Meanwhile, when there is no direct measurement point for 0.5 CR or 1.5 CR, a corresponding value may be estimated from a polynomial expression of the first profile P1i in the graph 500 to the graph 700.

FIG. 9 illustrates a third profile of a battery resistance with respect to an SOC, according to some embodiments.

Referring to FIG. 9, a graph 900 indicating a third profile P3 of a battery resistance with respect to an SOC is shown.

In the graph 900, the third profile P3 may be generated by collecting a resistance value at each SOC value. For example, a plurality of charging/discharging rates CR and voltage values may be provided at respective SOC values in the graph 800, and the charging/discharging rate CR may correspond to a current value, such that a resistance value at each SOC value may be estimated based on a pattern of these values.

The third profile P3 may be compared with a reference resistance profile 910, thereby estimating a resistance degradation state of the management target battery 120. According to an embodiment, the reference resistance profile 910 may mean a resistance for each SOC measured in a beginning of life (BOL) state of the management target battery 120. It may be determined that as a resistance difference ΔR between the third profile P3 and the reference resistance profile 910 increases, resistance degradation of the management target battery 120 is serious.

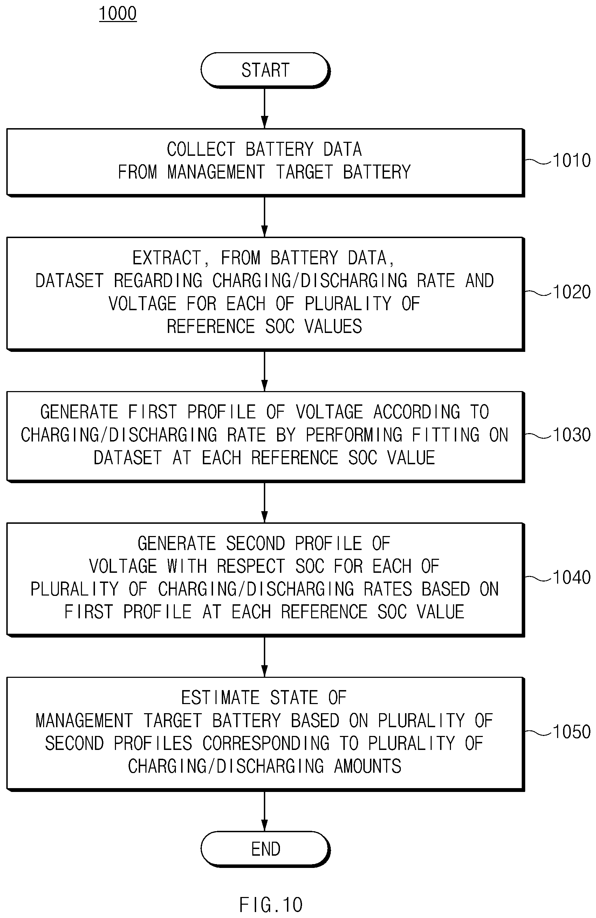

FIG. 10 illustrates operations of a battery management method according to some embodiments.

Referring to FIG. 10, a battery management method 1000 may include operations 1010 to 1050. However, without being limited thereto, some operations may be omitted and other general-purpose operations may be added, and operations of the battery management method 1000 may be executed in an order different from that shown.

The battery management method 1000 may include operations processed in time series by the battery management apparatus 130. Therefore, matters described for the battery management apparatus 130 above, even omitted below, may be equally applied to the battery management method 1000.

Operations 1010 to 1050 of the battery management method 1000 may be performed by the sensor 131 and the controller 132 of the battery management apparatus 130.

In operation 1010, the battery management apparatus 130 may collect battery data from the management target battery.

In operation 1020, the battery management apparatus 130 may extract a dataset Si regarding a charging/discharging rate (C-rate) CR and a voltage for each of the plurality of reference SOC values SOC1 to SOCn from the battery data.

In operation 1030, the battery management apparatus 130 may generate the first profile P1i of the voltage with respect to the charging/discharging rate CR by performing fitting for the dataset Si at each reference SOC value SOCi.

In operation 1040, the battery management apparatus 130 may generate the second profile P2j of the voltage with respect to the SOC for each of the plurality of charging/discharging rates CR1 to CRm based on the first profile P1i at each reference SOC value SOCi.

In operation 1050, the battery management apparatus 130 may estimate a state of the management target battery based on the plurality of second profiles P2₁ to P2ₘ corresponding to the plurality of charging/discharging rates CR1 to CRm.

According to an embodiment, the battery management method 1000 may be implemented in the form of a computer program stored on a computer-readable storage medium. That is, the computer program may include instructions for implementing the battery management method 1000, and the instructions of the program may be stored on a computer-readable storage medium. The computer programs may include mobile applications.

According to an embodiment, the computer-readable storage medium may include magnetic media such as hard disk, floppy disk, and magnetic tape, optical media such as compact disk read only memory (CD-ROM) and digital versatile disk (DVD), magneto-optical media such as floptical disk, and a hardware device especially configured to store and execute program instructions, such as ROM, RAM and flash memory, etc. The computer program instructions may include a machine language code created by a complier and a high-level language code executable by a computer using an interpreter.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

### [EXPLANATION OF REFERENCE NUMERALS]

| | | | |
|---|---|---|---|
| 100: | Battery Management System | 110: | Power-Using Device |
| 120: | Management Target Battery | 130: | Battery Management Apparatus |
| 131: | Sensor | 132: | Controller |
| 140: | Management Server | | |

## Claims

1. A battery management apparatus comprising:
a sensor configured to collect battery data from a management target battery; and
a controller configured to:
extract, from the battery data, a dataset regarding charging/discharging rate and a voltage for each of a plurality of reference state of charge (SOC) values;
generate a first profile of a voltage with respect to a charging/discharging rate by performing fitting on the dataset at each reference SOC value;
generate a second profile of a voltage with respect to an SOC for each of a plurality of charging/discharging rates based on the first profile at each reference SOC value; and
estimate a state of the management target battery based on a plurality of second profiles corresponding to the plurality of charging/discharging rates.

2. The battery management apparatus of claim 1, wherein the controller is further configured to generate the first profile by performing optimized polynomial fitting on the dataset at each reference SOC value.

3. The battery management apparatus of claim 2, wherein the controller is further configured to:
determine a polynomial order that is most appropriate for the dataset; and
generate the first profile by minimizing a difference between the dataset of the estimated polynomial expression according to the polynomial order.

4. The battery management apparatus of claim 1, wherein the controller is further configured to:
generate a third profile of a resistance of the management target battery with respect to an SOC based on the plurality of second profiles; and
estimate a resistance degradation state of the management target battery based on the third profile.

5. The battery management apparatus of claim 4, wherein the controller is further configured to estimate the resistance degradation state by comparing the third profile with a resistance profile at a manufacturing time of the management target battery.

6. The battery management apparatus of claim 1, wherein the controller is further configured to:
generate correction data by performing current accumulation and Kalman filter error correction on the battery data; and
extract the dataset based on the correction data.

7. The battery management apparatus of claim 1, wherein the sensor is configured to collect the battery data from the management target battery charged or discharged by a power-using device comprising the management target battery.

8. A battery management method comprising:
collecting battery data from a management target battery;
extracting, from the battery data, a dataset regarding a charging/discharging rate and a voltage for each of a plurality of reference state of charge (SOC) values;
generating a first profile of a voltage with respect to a charging/discharging rate by performing fitting on the dataset at each reference SOC value;
generating a second profile of a voltage with respect to an SOC for each of a plurality of charging/discharging rates based on the first profile at each reference SOC value; and
estimating a state of the management target battery based on a plurality of second profiles corresponding to the plurality of charging/discharging rates.

9. The battery management method of claim 8, wherein the generating of the first profile comprises generating the first profile by performing optimized polynomial fitting on the dataset at each reference SOC value.

10. The battery management method of claim 9, wherein the generating of the first profile comprises:
determining a polynomial order that is most appropriate for the dataset; and
generating the first profile by minimizing a difference between the dataset of the estimated polynomial expression according to the polynomial order.

11. The battery management method of claim 8, further comprising:
generating a third profile of a resistance of the management target battery with respect to an SOC based on the plurality of second profiles; and
estimating a resistance degradation state of the management target battery based on the third profile.

12. The battery management method of claim 11, wherein the estimating of the resistance degradation state comprises estimating the resistance degradation state by comparing the third profile with a resistance profile at a manufacturing time of the management target battery.

13. The battery management method of claim 8, wherein the extracting of the dataset comprises:
generating correction data by performing current accumulation and Kalman filter error correction on the battery data; and
extracting the dataset based on the correction data.

14. The battery management method of claim 8, wherein the collecting of the battery data comprises collecting the battery data from the management target battery charged or discharged by a power-using device comprising the management target battery.

15. A battery management system comprising:
a management target battery charged or discharged by a power-using device; and
a battery management apparatus configured to collect battery data from a management target battery, extract, from the battery data, a dataset regarding charging/discharging rate and a voltage for each of a plurality of reference state of charge (SOC) values, generate a first profile of a voltage with respect to a charging/discharging rate by performing fitting on the dataset at each reference SOC value, generate a second profile of a voltage with respect to an SOC for each of a plurality of charging/discharging rates based on the first profile at each reference SOC value, and estimate a state of the management target battery based on a plurality of second profiles corresponding to the plurality of charging/discharging rates.
